# EUROPÄISCHE PATENTSCHRIFT

(11) **EP 2 861 938 B1**
(45) Veröffentlichungstag und Bekanntmachung des Hinweises auf die Patenterteilung: **12.09.2018**
(21) Anmeldenummer: 13729320.5
(22) Anmeldetag: 12.06.2013
(51) Int. Cl.: G01D 5/241, G01L 1/14, G06F 3/0338, H01G 5/013, H03K 17/975

(54) **KAPAZITIVER SENSOR ZUR ERFASSUNG DER BEWEGUNG EINES OBJEKTS**
CAPACITIVE SENSOR FOR DETECTING THE MOVEMENT OF AN OBJECT
CAPTEUR CAPACITIF POUR LA DÉTECTION DU MOUVEMENT D'UN OBJET

(30) Priorität: 19.06.2012 DE 102012210277
(43) Veröffentlichungstag der Anmeldung: 22.04.2015
(73) Patentinhaber: Behr-Hella Thermocontrol GmbH, 70469 Stuttgart (DE)
(72) Erfinder: MARQUAS, Karsten, 59757 Arnsberg (DE); STEINKAMP, Michael, 59558 Lippstadt (DE); SCHLÜTER, Dirk, 59557 Lippstadt (DE)
(74) Vertreter: dompatent von Kreisler Selting Werner - Partnerschaft von Patent- und Rechtsanwälten mbB
(86) Internationale Anmeldenummer: PCT/EP2013/062157
(87) Internationale Veröffentlichungsnummer: WO 2013/189807

(56) Entgegenhaltungen:
- EP-A2- 1 698 876
- EP-A2- 2 154 503
- EP-B1- 1 261 845
- DE-A1-102007 001 086
- US-A- 5 206 785
- US-A1- 2008 202 251
- US-A1- 2009 273 483

## Beschreibung

Die Erfindung betrifft einen kapazitiven Sensor zur Erfassung der Bewegung eines Objekts, wobei es sich bei dem Objekt insbesondere um eine manuell bedienbare Taste einer Bedieneinheit insbesondere für eine Fahrzeugkomponente, wie beispielsweise ein Klimasteuergerät, ein Infotainment-Gerät, ein Navigationsgerät, ein Radio oder allgemein ein Mensch-Maschine-Interface handelt.

Die Erfassung der Bewegung eines Objekts in Form einer manuell bedienbaren Taste, deren Betätigung erfasst werden soll, erfolgt zumeist durch mechanische Schalter mit einem Schaltelement, das mit der Taste mechanisch gekoppelt ist. Bei Betätigung der Taste wird also das Schaltelement betätigt, welches wiederum einen Schaltkontakt ausführt, der die Betätigung der Taste signalisiert. Alternativ zu derartigen mechanischen Ansätzen existieren auch kapazitive Systeme, bei denen die Bewegung eines Objekts durch einen Kapazitätsveränderung erfasst wird. Auf den Beispielfall einer Bedienelement-Taste bezogen, verändert sich also bei Betätigung der Taste beispielsweise der Abstand zweier Elektroden des Kondensators eines kapazitiven Sensors, was signaltechnisch ausgewertet werden kann. Damit die beiden Elektroden eine Relativbewegung ausführen können, muss das sich zwischen den beiden Elektroden bildende Volumen kompressibel bzw. dehnbar sein. Als Dielektrikum bietet sich insoweit ein Gas und insbesondere Luft an. Nachteilig dabei ist allerdings, dass Luft bzw. allgemein Gas eine lediglich relativ geringe Dielektrizitätskonstante aufweist, Kapazitätsveränderungen infolge einer Abstandsveränderung der Elektroden also lediglich geringe Signalveränderungen verursachen.

In EP-A-2 154 503 ist ein kapazitiver Wegsensor beschrieben, bei dem anhand einer Veränderung der Kapazität ein Wegsignal ermittelt wird. Im Oberbegriff des Anspruchs 1 wird von diesem bekannten Wegsensor ausgegangen. Weitere kapazitiv arbeitende Sensoren sind aus EP-A-1 698 876, US-A-2008/0202251 und US-A-2009/0273483 bekannt.

Diverse weitere Ausbildungen von kapazitiven Sensoren, bei denen die in Folge einer Wirkkraft veränderte elektrische Kopplung der Elektroden genutzt wird, sind in DE-A-10 2007 001 086, EP-B-1 261 845 (sowie US-B-6 683 780) und US-A-5 206 785 beschrieben. Dabei wird bei dem Sensor nach DE-A-10 2007 001 086 ein festes Dielektrikum verwendet, von dem beabstandet eine elektrisch leitfähige, flexible Schicht angeordnet ist. Bei Druckausübung wirkt ein Stößel auf diese Schicht und bewegt diese auf das Dielektrikum zu sowie in mehr oder weniger großem flächigen Kontakt mit dem Dielektrikum, wodurch der gewünschte Signalhub des Ausgangssignals des Sensors gegeben ist. Auch bei dem Sensor nach US-A-5 206 785 wird ein festes Dielektrikum verwendet. In EP-B-1 261 845 und US-B-6 683 780 wird ein kapazitiver Differentialsensor mit Luft als Dielektrikum beschrieben.

Aufgabe der Erfindung ist es, einen kapazitiven Sensor zur Erfassung der Bewegung eines Objekts zu schaffen, der auch bei kleinen Bewegungen einfach erfassbare und damit ausreichend große Messsignalveränderungen erzeugt.

Zur Lösung dieser Aufgabe wird mit der Erfindung ein kapazitiver Sensor zur Erfassung der Bewegung eines Objekts, insbesondere zur Erfassung der Betätigung einer Taste einer Bedieneinheit vorgeschlagen, wobei der kapazitive Sensor versehen ist mit den Merkmalen des Anspruchs 1. Die anderen Ansprüche betreffen einzelne Ausgestaltungen der Erfindung.

Der erfindungsgemäße kapazitive Sensor weist einen Kondensator auf, der eine erste und eine zweite Elektrode mit einem Volumen zwischen diesen umfasst. Eine der beiden Elektroden ist mit dem Objekt verbunden oder mit diesem mechanisch gekoppelt bzw. an dem Objekt angeordnet, so dass sich die Elektrode bewegt, wenn sich das Objekt bewegt. Bei Bewegung der Elektrode verändert sich ihr Abstand zur anderen Elektrode. Damit verändert sich also auch das Volumen zwischen den beiden Elektroden. Als Volumen zwischen den beiden Elektroden wird derjenige Bereich aufgefasst, der einerseits durch die Elektroden selbst und seitlich der Elektroden begrenzt ist. Die beiden Elektroden sind mit einer Auswerteeinheit zur Ermittlung von Kapazitätsveränderungen des Kondensators verbunden.

Erfindungsgemäß ist das Volumen zwischen den beiden Elektroden zumindest teilweise von einem verformbaren ersten Dielektrikum ausgefüllt, das nicht gasförmig ist. Ein weiterer Teil des Volumens zwischen den beiden Elektroden ist von Gas ausgefüllt. Dieses Gasvolumen kann von dem ersten Dielektrikum gebildet sein oder kann sich zwischen dem ersten Dielektrikum und einer oder beider Elektroden bilden. Das Gasvolumen ist von einem gasförmigen zweiten Dielektrikum ausgefüllt. Bei Annäherung der beiden Elektroden entweicht nun aus dem Gasvolumen gasförmiges zweites Dielektrikum; umgekehrt könnte bei einer Abstandsvergrößerung der beiden Elektroden in das Gasvolumen von außen gasförmiges zweites Dielektrikum eindringen. Bei einer Abstandsänderung der beiden Elektroden kommt es also zu einer Veränderung des einerseits von dem ersten Dielektrikum eingenommenen Anteils und des andererseits von dem zweiten Dielektrikum eingenommenen Anteils des Volumens zwischen den Elektroden. Diese Anteilsveränderungen führen zu einer Verstärkung der Kapazitätsveränderung, die messtechnisch erfasst wird, weshalb auch kleinere Elektroden- und damit Objektbewegungen messtechnisch zuverlässig und mit geringem Aufwand erfasst werden können.

Nach der Erfindung ist ferner vorgesehen, dass das erste Dielektrikum ein nach Art einer Linse ausgebildeter Formkörper mit zwei zu den Elektroden weisenden sphärischen Außenseiten ist und dass das Gasvolumen zwischen den Außenseiten und den Elektroden gebildet ist.

Bei einer bevorzugten Ausgestaltung der Erfindung können zwei Kondensatoren gegensinnig eingesetzt werden, um die Bewegung eines Objekts zu erfassen. Dabei ist die Anordnung derart gewählt, dass bei einer Bewegung des Objekts sich der Abstand der Elektroden des einen Kondensators verringert, während sich der Abstand der Elektroden des anderen Kondensators vergrößert. Beide Kondensatoren sind im Wesentlichen gleich aufgebaut, weisen also jeweils ein nicht gasförmiges erstes Dielektrikum und ein gasförmiges zweites Dielektrikum auf. Hierdurch erhöht sich die Messgenauigkeit weiter und die Zuverlässigkeit der Erfassung einer Bewegung des Objekts entsprechend.

Im Einzelnen ist bei dieser Ausgestaltung der Erfindung vorgesehen, dass ein zweiter Kondensator vorgesehen ist, der eine erste Elektrode und eine zur Verbindung oder mechanischen Kopplung mit oder zur Anordnung an dem Objekt vorgesehenen zweiten Elektrode aufweist, wobei sich bei Bewegung des Objekts die Abstände der Elektroden der beiden Kondensatoren gegensinnig verändern, wobei beide Kondensatoren zwischen sich ein nicht gasförmiges erstes und ein gasförmiges zweites Dielektrikum aufweisen und wobei die Elektroden beider Kondensatoren mit der Auswerteeinheit verbunden sind.

Das Gasvolumen des ersten Dielektrikums bzw. das Gasvolumen zwischen dem ersten Dielektrikum und mindestens einer der beiden Elektroden wird zweckmäßigerweise dadurch realisiert, dass das erste Dielektrikum mindestens eine zur Umgebung hin offene Ausnehmung aufweist, aus der Gas (d.h. zweites Dielektrikum) entweichen kann, wenn sich die beiden Elektroden annähern. Alternativ kann die Oberfläche des ersten Dielektrikums profiliert bzw. strukturiert sein, also nach außen hin offene Aufnahmeräume für Gas aufweisen. In jedem Fall ist sicherzustellen, dass das Gas aus dem vom zweiten Dielektrikum ausgefüllten Gasvolumen entweichen kann, und zwar bis aus dem Zwischenraum zwischen den beiden Elektroden heraus.

In vorteilhafter Weiterbildung der Erfindung kann vorgesehen sein, dass das erste Dielektrikum rückstellfähig ist. Nach einer Verformung infolge einer Veränderung des Elektrodenabstands nimmt damit das erste Dielektrikum automatisch wieder seine ursprüngliche Form an. In diesem Zusammenhang ist es von Vorteil, wenn das erste Dielektrikum mit den Elektroden verbunden ist, und zwar insbesondere an deren einander zugewandten (Innen-)Flächen. Die Rückstellfähigkeit des ersten Dielektrikums ermöglicht es, das erste Dielektrikum sozusagen auch für die Lagerung des Objekts, dessen Bewegung erfasst werden soll, zu nutzen. Außerdem sorgt ein rückstellfähiges erstes Dielektrikum für eine automatische Überführung des Objekts in die Ruhestellung, die es vor einer Bewegung eingenommen hat. Bei Anordnung zweier Kondensatoren, wie oben beschrieben, wirken also auf das Objekt von zwei gegenüberliegenden Seiten gegensinnig gerichtete Rückstellkräfte, die das Objekt wieder in die Ruheposition überführen, aus der es heraus bewegt worden ist.

Als Material für das erste Dielektrikum kommt insbesondere ein Elastomer und vorzugsweise Gummi vor. Das erste Dielektrikum kann porös bzw. offenzellig ausgebildet sein. Insbesondere eignet sich ein Schaummaterial, das insoweit kompressibel ist, als die offenzelligen Gasvolumina unter Entweichung des Gases nach außen zusammengedrückt werden können, wenn die beiden Elektroden sich einander annähern.

Die Erfindung betrifft darüber hinaus eine Bedieneinheit für eine Fahrzeugkomponente, insbesondere ein Klimasteuergerät, ein Infotainment-Gerät, ein Navigationsgerät, ein Radio oder allgemein ein Mensch-Maschine-Interface, wobei die Bedieneinheit versehen ist mit einer manuell betätigbaren, bewegbaren Taste, insbesondere einer Kipp-, Wipp- oder Drucktaste, und einem kapazitiven Sensor zur Erfassung einer Bewegung und damit einer Betätigung der Taste, wobei der kapazitive Sensor gemäß einem oder mehreren der Ansprüche ausgebildet sein kann.

Der erfindungsgemäße kapazitive Sensor zur Erfassung der Bewegung eines Objekts kann, wie sich aus dem Vorstehenden ergibt, als Kraft- bzw. Druck- und/oder als Wegsensor fungieren, jedoch stets in der Applikation zur Erfassung der Bewegung eines Objekts.
Die Erfindung wird nachfolgend anhand zweier Ausführungsbeispiele und unter Bezugnahme auf die Zeichnung näher erläutert. Im Einzelnen zeigen dabei:
- Fig. 1: einen Querschnitt durch einen Teil einer Fahrzeug-Bedieneinheit mit einer Balkon-(Kipp-)Taste, deren Betätigung durch eine kapazitive Sensorik erfasst wird, und
- Fig. 2: einen Teilquerschnitt durch eine Fahrzeug-Bedieneinheit gemäß einem anderen Ausführungsbeispiel mit einer Drucktaste und einer kapazitiven Sensorik zur Erkennung der Betätigung der Drucktaste.

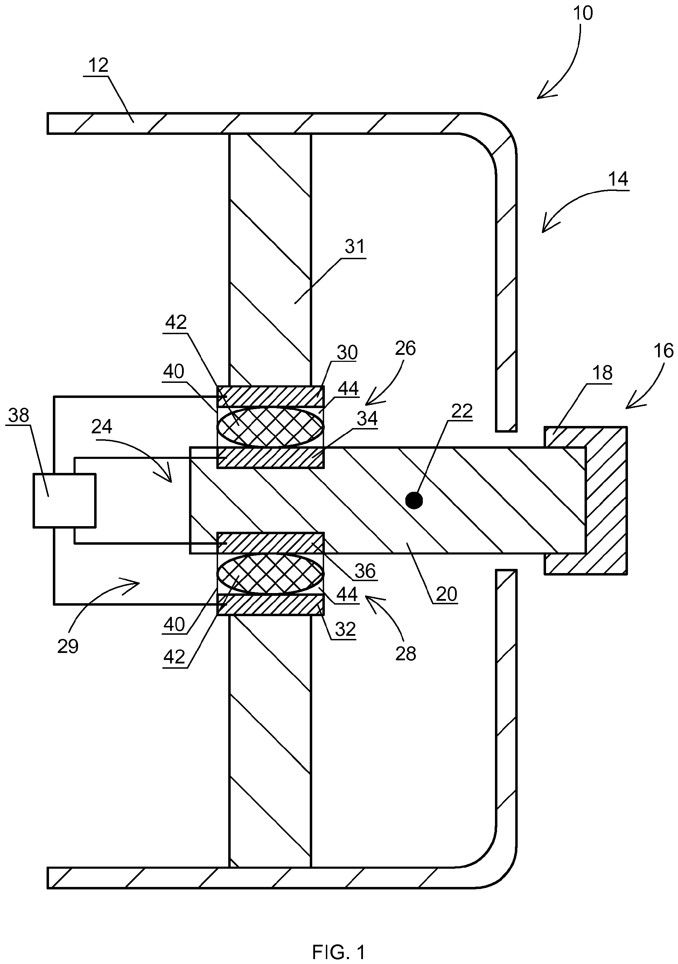

In Fig. 1 ist im Querschnitt und stark vereinfacht der für die Erfindung wesentliche Teil einer Fahrzeug-Bedieneinheit 10 mit einer Kipptaste gezeigt, deren Betätigung kapazitiv erkannt wird. Die Fahrzeug-Bedieneinheit 10 weist ein Gehäuse 12 auf, über dessen Vorderseite 14 das Bedienende 16 einer Betätigungstaste 18 vorsteht. Die Betätigungstaste 18 ist an einen hebel- bzw. plattenförmigen Halter 20 angeordnet, der um eine Kippachse 22 im Gehäuse 12 drehbar gelagert ist. Ober- und unterhalb seines der Betätigungstaste 18 abgewandten hinteren Endes 24 befinden sich ein erster und ein zweiter Kondensator 26,28. Jeder Kondensator 26,28 weist eine feststehende erste Elektrode 30,32 und eine bewegliche zweite Elektrode 34,36 auf. Die beiden ersten Elektroden 30,32 der beiden Kondensatoren 26,28 sind in diesem Ausführungsbeispiel an den einander gegenüberliegenden Randabschnitten einer Aussparung 29 in einem Trägerkörper 31 angeordnet, wobei das Ende 24 des Halters 20 der Betätigungstaste 18 in die Aussparung 29 eingetaucht ist. Die beiden zweiten Elektroden 34,36 sind an gegenüberliegenden Seiten des hebelförmigen bzw. plattenförmigen Halters 20, also auf dessen Ober- und dessen Unterseite angeordnet. Jeder ersten Elektrode 30 bzw. 32 liegt also eine zweite Elektrode 34,36 gegenüber. Wenn die Betätigungstaste 18 gekippt wird, so verändern sich die Abstände der zweiten Elektroden 34,36 von den ihnen zugeordneten ersten Elektroden 30 bzw. 32 der beiden Kondensatoren 26,28 gegensinnig. Durch diese Elektrodenabstandsveränderungen (in in diesem Ausführungsbeispiel entgegengesetzter Richtung, also gegensinnig) verändert sich die Kapazität jedes Kondensators 26,28, was durch eine Auswerteeinheit 38 messtechnisch erfasst und ausgewertet wird. Damit lässt sich also eine Bedienung der Betätigungstaste 18 ermitteln.

Wie in Fig. 1 angedeutet, definieren die beiden Elektrodenpaare der Kondensatoren 26,28 zwischen sich jeweils ein Volumen 40. Das Volumen 40 ist in der Ausgangsstellung der Betätigungstaste 18 gemäß Fig. 1 teilweise von einem ersten Dielektrikum 42 ausgefüllt. In diesem Ausführungsbeispiel weist das erste Dielektrikum 42 die Form einer Linse auf. Das erste Dielektrikum 42 besteht aus einem nicht gasförmigen Material, bei dem es sich in diesem Ausführungsbeispiel um ein Elastomer bzw. um Gummi handelt. Das erste Dielektrikum 42 ist also in diesem Ausführungsbeispiel rückstellfähig. Auf Grund der Linsenform liegt das erste Dielektrikum 42 nicht vollflächig an den betreffenden Elektroden 30 bis36 an; vielmehr bildet sich zwischen dem ersten Dielektrikum 42 und den zugehörigen Elektroden 30 bis 36 ein Gasvolumen 44, das mehrere Teilvolumina aufweist. Diese Teilvolumina sind mit Luft ausgefüllt, wenn sich die Betätigungstaste 18 in ihrer Ausgangsstellung befindet.

Wird nun die Betätigungstaste 18 bedient, so verschwenkt der Halter 20 mit der Folge, dass der Elektrodenabstand des einen Kondensators sich verringert und der Elektrodenabstand des anderen Kondensators sich vergrößert. Bei einer Verringerung des Elektrodenabstandes wird Luft aus den Gasvolumina 44 herausgedrückt und letztendlich durch Material des Dielektrikums 42 "ersetzt". Damit sinkt also der Anteil an Luft zwischen den Elektroden des besagten Kondensators, was zu einer Steigerung der Kapazitätsänderung führt, weshalb sich Bewegungen der Betätigungstaste 18 zuverlässiger und mit größeren Signalhüben erkennen lassen. Hierzu trägt auch der Umstand bei, dass die relative Dielektrizitätskonstante des Dielektrikums 42 wesentlich größer ist als die relative Dielektrizitätskonstante von Luft, die sich in den Gasvolumina 44 befindet.

Eine konstruktive Ausgestaltung der Anordnung gemäß Fig. 1 kann beispielsweise aus einer vertikal angeordneten Leiterplatte bestehen (siehe den Trägerkörper 31), in der ein durchkontaktiertes Langloch (siehe die Aussparung 29) ausgebildet ist. Die Durchkontaktierung wird dann an zwei gegenüberliegenden Enden durchtrennt, womit die beiden Elektroden 30,32 entstehen. In dem Langloch (siehe Aussparung 29) ist nun mittig eine weitere Elektrode angeordnet (nämlich bestehend aus den Elektroden 34 und 36). Bewegt sich nun diese in das Langloch eingetauchte Elektrode auf eine der beiden Elektroden 30,32 zu, so erhöht sich die elektrische Kapazität zwischen den betreffenden Elektroden, während sie zwischen den betreffenden anderen Elektroden abnimmt. Um die zu messende Kapazität zu steigern und um eine Kraft-Weg-Korrelation zu erzielen, wird zwischen die Elektroden ein elastisches Dielektrikum 42 (beispielsweise Gummi) eingebracht. Um die Kapazitätsänderung über den Weg zu steigern, wird das Dielektrikum 42 beispielsweise profiliert ausgeführt, so dass bei Verformung unter Krafteinwirkung der Anteil der durch die Profilierung vorhandenen Luft zwischen den Elektroden sinkt. Das Verhältnis aus von dem ersten Dielektrikum 42 eingenommenem Anteil und des von Luft ausgefüllten Anteils des Volumens zwischen den Elektroden verändert sich also, wenn sich der Elektrodenabstand verändert. Da Gummi bzw. das erste Dielektrikum eine wesentlich größere relative Dielektrizitätskonstante als Luft aufweist, verändert sich die Kapazität bei Abstandsveränderung der Elektroden also stärker als in dem Fall, in dem das Dielektrikum zwischen den unterschiedlich beabstandeten Elektroden stets das gleiche wäre. Somit wird eine einfach erfassbare Kapazitätsänderung erzielt, die darüber hinaus zuverlässig ist.

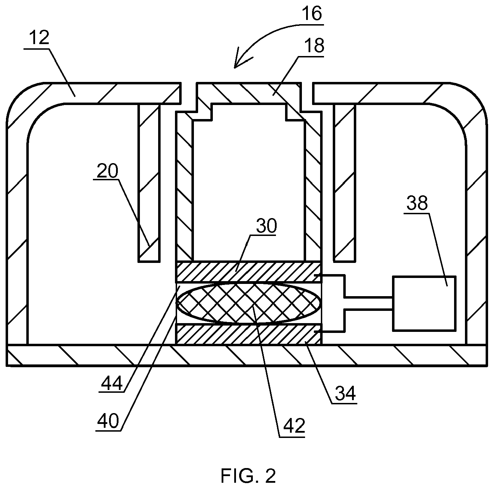

Fig. 2 zeigt ein alternatives Ausführungsbeispiel, bei dem die erfindungsgemäße kapazitive Sensorik für den Fall der Ausbildung der Betätigungstaste als Drucktaste Anwendung findet. Soweit die Elemente gemäß Fig. 1 denen der Fig. 2 entsprechen (d.h. konstruktiv gleich sind bzw. funktional ähnlich sind), sind sie in Fig. 2 mit den gleichen Bezugszeichen wie in Fig. 1 gekennzeichnet. Wie im Ausführungsbeispiel gemäß Fig. 1 kann also auch im Ausführungsbeispiel nach Fig. 2 das rückstellfähige erste Dielektrikum 42 zur automatischen Rückstellung der Betätigungstaste 18 genutzt werden, nachdem diese betätig und die Krafteinwirkung auf die Taste beendet wurde.

### BEZUGSZEICHENLISTE

- 10: Fahrzeug-Bedieneinheit
- 12: Gehäuse der Fahrzeug-Bedieneinheit
- 14: Vorderseite des Gehäuses
- 16: Bedienende einer Betätigungstaste
- 18: Betätigungstaste
- 20: Halter für die Betätigungstaste
- 22: Kippachse des Halters / der Betätigungstaste
- 24: Ende des Halters mit Kondensatoren
- 26: erster Kondensator
- 28: zweiter Kondensator
- 29: Aussparung im Trägerkörper
- 30: erste Elektrode des ersten Kondensators
- 31: Trägerkörper für erste Elektrode der beiden Kondensatoren
- 32: erste Elektrode des zweiten Kondensators
- 34: zweite Elektrode des ersten Kondensators
- 36: zweite Elektrode des zweiten Kondensators
- 38: Auswerteeinheit
- 40: Volumen zwischen den Elektroden eines Kondensators
- 42: Dielektrikum zwischen den Elektroden eines Kondensators
- 44: Gasvolumen zwischen den Elektroden eines Kondensators

## Patentansprüche

1. Kapazitiver Sensor zur Erfassung der Bewegung eines Objekts, insbesondere zur Erfassung der Betätigung einer Taste einer Bedieneinheit, mit
- einer ersten Elektrode (30;32),
- einer zur Verbindung oder mechanischen Kopplung mit oder zur Anordnung an dem Objekt vorgesehenen zweiten Elektrode (34;36), deren Abstand zur ersten Elektrode (30;32) sich bei Bewegung des Objekts verändert,
- wobei die beiden Elektroden (30,34;32,36) einen ersten Kondensator (26;28) mit einem Volumen (40) zwischen den Elektroden (30,34;32,36) bilden, dessen Größe sich bei Bewegung des Objekts ändert, und
- einer Auswerteeinheit (38), die mit den beiden Elektroden (30,34;32,36) verbunden ist und die eine sich zwischen den beiden Elektroden (30,34;32,36) bei deren Abstands- und Volumenänderung ergebende Kapazitätsveränderung ermittelt,
- wobei zwischen den beiden Elektroden (30,34;32,36) ein verformbares, nicht gasförmiges erstes Dielektrikum (42) angeordnet ist,
- wobei das erste Dielektrikum (42) mindestens ein Gasvolumen (44) aufweist oder mit mindestens einer der beiden Elektroden (30,34;32,36) ein Gasvolumen (44) definiert, das von einem gasförmigen zweiten Dielektrikum ausgefüllt ist,
- wobei bei Annäherung der beiden Elektroden (30,34;32,36) aus dem Gasvolumen (44) und aus dem Volumen (40) zwischen den beiden Elektroden zumindest ein Teil des zweiten Dielektrikums entweicht und
- wobei sich der von dem ersten Dielektrikum (42) eingenommene Anteil des Volumens (40) zwischen den beiden Elektroden (30,34;32,36) bei Annäherung der beiden Elektroden (30,34;32,36) vergrößert und sich der von dem zweiten Dielektrikum eingenommene Anteil des Volumens (40) zwischen den beiden Elektroden (30,34;32,36) verringert
**dadurch gekennzeichnet,**
- **dass** das erste Dielektrikum (42) ein nach Art einer Linse ausgebildeter Formkörper mit zwei zu den Elektroden (30,34;32,36) weisenden vorgewölbten Außenseiten ist und
- **dass** das Gasvolumen (44) zwischen den Außenseiten des Formkörpers und den Elektroden (30,34;32,36) gebildet ist.

2. Kapazitiver Sensor nach Anspruch 1, **dadurch gekennzeichnet, dass** das erste Dielektrikum (42) ein offenzelliges Material aufweist.

3. Kapazitiver Sensor nach Anspruch 1, **dadurch gekennzeichnet, dass** das erste Dielektrikum (42) rückstellfähig ist.

4. Kapazitiver Sensor nach Anspruch 1 oder 2, **dadurch gekennzeichnet, dass** das erste Dielektrikum (42) ein Elastomer, insbesondere Gummi ist.

5. Kapazitiver Sensor nach einem der Ansprüche 1 bis 4, **dadurch gekennzeichnet, dass** das erste Dielektrikum (42) eine größere relative Dielektrizitätskonstante als das zweite Dielektrikum aufweist.

6. Kapazitiver Sensor nach einem der Ansprüche 1 bis 5, **gekennzeichnet durch** einen zweiten Kondensator (26;28), der eine erste Elektrode (30;32) und eine zur Verbindung oder mechanischen Kopplung mit oder zur Anordnung an dem Objekt vorgesehenen zweiten Elektrode (34;36) aufweist, wobei sich bei Bewegung des Objekts die Abstände der Elektroden (30,34;32,36) der beiden Kondensatoren (26;28) gegensinnig verändern, wobei beide Kondensatoren (26;28) zwischen sich ein nicht gasförmiges erstes und ein gasförmiges zweites Dielektrikum aufweisen und wobei die Elektroden (30,34;32,36) beider Kondensatoren (26;28) mit der Auswerteeinheit (38) verbunden sind.

## Claims

1. A capacitive sensor for detecting the movement of an object, particularly for detecting the actuation of a key of an operating unit, comprising
- a first electrode (30;32),
- a second electrode (34;36) provided for connection or mechanical coupling to, or for arrangement on, the object, the distance of the second electrode from the first electrode (30;32) changing when the object moves,
- wherein the two electrodes (30,34;32,36) form a first capacitor (26;28) with a volume (40) between the electrodes (30,34;32,36), the size of which changes when the object moves, and
- an evaluation unit (38) connected to the two electrodes (30,34; 32,36) and operative to determine a change of capacitance between the two electrodes (30,34;32,36) resulting from a change of their spacing and volume,
- wherein a deformable, non-gaseous first dielectric (42) is arranged between the two electrodes (30,34;32,36),
- wherein the first dielectric (42) defines at least one gas volume (44) or, together with at least one of the two electrodes (30,34;32,36) defines a gas volume (44) that is filled by a gaseous second dielectric,
- wherein, when the two electrodes (30,34;32,36) approach one another, at least a part of the second dielectric escapes from the gas volume (44) and from the volume (40) between the two electrodes and,
- wherein, when the two electrodes (30,34;32,36) approach one another, the portion of the volume (40) between the two electrodes (30,34; 32,36) occupied by the first dielectric (42) increases and the portion of the volume (40) between the two electrodes (30,34;32, 36) occupied by the second dielectric decreases,
**characterized in**
- **that** the first dielectric (42) is a shaped body formed in the manner of a lens and having two protruding outer sides facing toward the electrodes (30,34;32,36) and
- **that** said gas volume (44) is formed between the outer sides and the electrodes (30,34;32,36).

2. The capacitive sensor according to claim 1, **characterized in that** the first dielectric (42) comprises an open-celled material.

3. The capacitive sensor according to claim 1, **characterized in that** the first dielectric (42) is resilient.

4. The capacitive sensor according to claim 1 or 2, **characterized in that** the first dielectric (42) is an elastomer, particularly rubber.

5. The capacitive sensor according to any one of claims 1 to 4, **characterized in that** the first dielectric (42) has a larger relative dielectric constant than the second dielectric.

6. The capacitive sensor according to any one of claims 1 to 5, **characterized by** a second capacitor (26;28) which comprises a first electrode (30;32) and a second electrode (34;36) provided for connection or mechanical coupling to, or for arrangement on, the object, wherein, in case of a movement of the object, the distances between the electrodes (30,34;32,36) of the two capacitors (26;28) will change in opposite senses, wherein both capacitors (26;28) comprise between them a non-gaseous first and a gaseous second dielectric, and wherein the electrodes (30,34;32,36) of both capacitors (26;28) are connected to the evaluation unit (38).

## Revendications

1. Capteur capacitif destiné à la détection du mouvement d'un objet, en particulier destiné à la détection de l'actionnement d'une touche d'une unité de commande, avec
- une première électrode (30 ; 32),
- une deuxième électrode (34 ; 36), prévue pour le raccordement ou le couplage mécanique avec l'objet ou pour être disposée sur l'objet, dont la distance à la première électrode (30 ; 32) varie lors du mouvement de l'objet,
- les deux électrodes (30, 34 ; 32, 36) formant un premier condensateur (26 ; 28) avec un volume (40) entre les électrodes (30, 34 ; 32, 36) dont la grandeur varie lors du mouvement de l'objet, et
- une unité d'analyse (38) qui est raccordée aux deux électrodes (30, 34 ; 32, 36) et qui détermine une variation de capacité résultant entre les deux électrodes (30, 34 ; 32, 36) lors de leur variation de distance et de volume,
- un premier diélectrique (42) déformable non gazeux étant disposé entre les deux électrodes (30, 34 ; 32, 36),
- le premier diélectrique (42) présentant au moins un volume de gaz (44) ou définissant avec au moins une des deux électrodes (30, 34 ; 32, 36) un volume de gaz (44) qui est rempli d'un deuxième diélectrique gazeux,
- au moins une partie du deuxième diélectrique s'échappant, lors du rapprochement des deux électrodes (30, 34 ; 32, 36), du volume de gaz (44) et du volume (40) entre les deux électrodes, et
- la fraction du volume (40) absorbée par le premier diélectrique (42) entre les deux électrodes (30, 34 ; 32, 36) augmentant lors du rapprochement des deux électrodes (30, 34 ; 32, 36), et la fraction du volume (40) absorbée par le deuxième diélectrique diminuant entre les deux électrodes (30, 34 ; 32, 36),
**caractérisé en ce que**
- le premier diélectrique (42) est un corps moulé constitué à la façon d'une lentille, avec deux côtés extérieurs précintrés dirigés vers les électrodes (30, 34 ; 32, 36), et
- **en ce que** le volume de gaz (44) est formé entre les côtés extérieurs du corps moulé et les électrodes (30, 34 ; 32, 36).

2. Capteur capacitif selon la revendication 1, **caractérisé en ce que** le premier diélectrique (42) présente un matériau à cellules ouvertes.

3. Capteur capacitif selon la revendication 1, **caractérisé en ce que** le premier diélectrique (42) est susceptible d'effectuer un mouvement de rappel.

4. Capteur capacitif selon la revendication 1 ou 2, **caractérisé en ce que** le premier diélectrique (42) est un élastomère, en particulier du caoutchouc.

5. Capteur capacitif selon l'une des revendications 1 à 4, **caractérisé en ce que** le premier diélectrique (42) présente une constante diélectrique relative plus élevée que le deuxième diélectrique.

6. Capteur capacitif selon l'une des revendications 1 à 5, **caractérisé par** un deuxième condensateur (26 ; 28) qui présente une première électrode (30 ; 32) et une deuxième électrode (34 ; 36) prévue pour le raccordement ou le couplage mécanique avec l'objet ou pour être disposée sur l'objet, les distances des électrodes (30, 34 ; 32, 36) des deux condensateurs (26 ; 28) variant en sens inverse lors du mouvement de l'objet, les deux condensateurs (26 ; 28) présentant entre eux un premier diélectrique non gazeux et un deuxième diélectrique gazeux, et les électrodes (30, 34 ; 32, 36) des deux condensateurs (26 ; 28) étant raccordées à l'unité d'analyse (38).
